# EUROPEAN PATENT APPLICATION

(11) **EP 4 351 304 A2**
(43) Date of publication of application: **10.04.2024**
(21) Application number: 23201676.6
(22) Date of filing: 04.10.2023
(51) Int. Cl.: H10N 50/01, H10N 50/10, H10N 50/85

(54) **SYSTEMS AND METHODS FOR HIGH OXIDATION TIME TO SUPPRESS BIT ERROR RATE**

(30) Priority: 03.10.2022 US 202263378217 P; 02.10.2023 US 202318479226
(71) Applicant: Everspin Technologies, Inc., Chandler, AZ 85226 (US)
(72) Inventor: SUN, Jijun, CHANDLER, 85226 (US); NAGEL, Kerry Joseph, CHANDLER, 85226 (US)
(74) Representative: Eisenführ Speiser

(57) **Abstract**

A magnetoresistive stack may include a fixed magnetic region, where the fixed magnetic region may include a reference layer, an interfacial layer disposed above the reference layer, an intermediate layer disposed above the interfacial layer, and a free magnetic region disposed above the intermediate layer. The interfacial layer may include cobalt (Co).

## Description

### CROSS-REFERENCE TO RELATED APPLICATION(S)

This application claims the benefit of priority to U.S. Provisional Patent Application No. 63/378,217, filed October 3, 2022, the entire contents of which are incorporated herein by reference.

### TECHNICAL FIELD

Various embodiments of the present disclosure relate generally to a semiconductor manufacturing process leading to performance benefits and, more particularly, to forming magnetoresistive stacks with improved performance.

### INTRODUCTION

In general, a memory system may include a memory device for storing data and a host (or controller) for controlling operations of the memory device. Memory devices may be classified into, e.g., volatile memory (such as, e.g., DRAM or SRAM) and non-volatile memory (such as EEPROM, FRAM (Ferroelectric RAM), PRAM (Phase-change memory), MRAM (magnetoresistive memory), RRAM/ReRAM (resistive memory) and Flash memory).

A magnetoresistive stack used in a memory device (e.g., an MRAM device) includes at least one non-magnetic layer (for example, at least one dielectric layer or a non-magnetic yet electrically conductive layer) disposed between a fixed magnetic region (e.g., a fixed region) and a free magnetic region (e.g., a free region), each including one or more layers of ferromagnetic materials. Information may be stored in the magnetoresistive stack by switching, programming, and/or controlling the direction of magnetization vectors in the magnetic layer(s) of the free region. The direction of the magnetization vectors of the free region may be switched and/or programmed (for example, through spin transfer torque (STT)) by application of a write signal (e.g., one or more current pulses) adjacent to, or through, the magnetoresistive memory stack. In contrast, the magnetization vectors in the magnetic layers of a fixed region are magnetically fixed in a predetermined direction. When the magnetization vectors of the free region adjacent to the non-magnetic layer are in the same direction as the magnetization vectors of the fixed region adjacent to the non-magnetic layer, the magnetoresistive memory stack has a first magnetic state. Conversely, when the magnetization vectors of the free region adjacent to the non-magnetic layer are opposite the direction of the magnetization vectors of the fixed region adjacent to the non-magnetic layer, the magnetoresistive memory stack has a second magnetic state. Together, the magnetic regions on either side of the non-magnetic layer form a magnetic tunnel junction (MTJ) when the non-magnetic layer is a dielectric material. The MTJ has different electrical resistances in the first and second magnetic states. For example, a resistance of the second magnetic state may be relatively higher than a resistance of the first magnetic state. The magnetic state of the magnetoresistive memory stack is determined or read based on the resistance of the stack in response to a read current applied, for example, through the magnetoresistive stack.

A high bit error rate (BER) is generally disadvantageous for memory devices and may require a greater amount of error correction codes (ECCs). The opportunity to efficiently apply ECCs may be even more limited for memory devices that are used in a distributed manner (e.g., distributed memory in a configuration bit for a field programmable gate array (FPGA)).

### BRIEF DESCRIPTION OF THE DRAWINGS

In the course of the detailed description that follows, reference will be made to the appended drawings. The drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present inventions.
FIGS. 1A and 1B illustrate cross-sectional views depicting various regions of exemplary magnetoresistive stacks, according to one or more embodiments of the present disclosure.
FIGS. 2A and 2B illustrate cross-sectional views of various regions including a free region of exemplary magnetoresistive stacks, according to one or more embodiments of the present disclosure.
FIGS. 3A, 3B, and 4 illustrate cross-sectional views of various regions including a fixed region of exemplary magnetoresistive stacks, according to one or more embodiments of the present disclosure.
FIG. 5 is a flowchart of a method of manufacturing an exemplary magnetoresistive stack, according to one or more embodiments of the present disclosure.
FIG. 6 is a flowchart of another method of manufacturing an exemplary magnetoresistive stack, according to one or more embodiments of the present disclosure.
FIG. 7 is a flowchart of another method of manufacturing exemplary magnetoresistive stacks, according to one or more embodiments of the present disclosure.
FIGS. 8A-8C are flowcharts of various methods describing the process for forming an intermediate layer for one or more exemplary magnetoresistive stacks, according to one or more embodiments of the present disclosure.
FIG. 9 is a schematic diagram of an exemplary magnetoresistive memory stack electrically connected to a select device, e.g., an access transistor, in a magnetoresistive memory cell configuration, according to one or more embodiments of the present disclosure.
FIGS. 10A and 10B are schematic block diagrams of integrated circuits including a discrete memory device and an embedded memory device, each including MRAM (which, in one embodiment is representative of one or more arrays of MRAM having a plurality of magnetoresistive memory stacks), according to one or more embodiments of the present disclosure.
FIG. 11 is an exemplary quantile plot depicting normalized resistance-area product (RA) values for a plurality of wafers that have been tested with and without an interfacial layer, according to one or more embodiments of the present disclosure.
FIG. 12 is an exemplary quantile plot depicting normalized RA values for a plurality of wafers that have been tested with and without a delay of time step between a deposition and an oxidation process, according to one or more embodiments of the present disclosure.
FIG. 13 illustrates exemplary charts comparing a normalized bit error rate (BER) and normalized endurance cycles against a normalized RA for two fabrication processes, according to one or more embodiments of the present disclosure.

Again, there are many embodiments described and illustrated herein. The present disclosure is neither limited to any single aspect nor embodiment thereof, nor to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

As used herein, the terms "comprises," "comprising," or any other variation thereof, are intended to cover a non-exclusive inclusion, such that a process, method, article, or apparatus that comprises a list of elements does not include only those elements, but may include other elements not expressly listed or inherent to such process, method, article, or apparatus. The term "exemplary" is used in the sense of "example," rather than "ideal."

### DETAILED DESCRIPTION OF EMBODIMENTS

The present disclosure generally relates to magnetoresistive devices having a magnetoresistive stack or structure (for example, part of a magnetoresistive memory device, magnetoresistive sensor/transducer device, etc.) and methods of manufacturing the described magnetoresistive devices.

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

It should be noted that all numeric values disclosed herein (including all disclosed thickness values, limits, and ranges) may have a variation of ±10% (unless a different variation is specified) from the disclosed numeric value. For example, a layer disclosed as being "t" units thick can vary in thickness from (t-0.1t) to (t+0.1t) units. Further, all relative terms such as "about," "substantially," "approximately," etc. are used to indicate a possible variation of ±10% (unless noted otherwise or another variation is specified). Moreover, in the claims, values, limits, and/or ranges of thickness and atomic composition of, for example, the described layers/regions, mean the value, limit, and/or range ±10%. It should be noted that the exemplary thickness values discussed in this disclosure are expected values (i.e., not measured values) of layer thicknesses immediately after deposition (based on deposition conditions, etc.). As a person of ordinary skill in the art would recognize, these as-deposited thickness values of a layer or region may change (e.g., by inter-layer diffusion, etc.) after further processing (e.g., exposure to high temperatures, etc.).

It should be noted that the description set forth herein is merely illustrative in nature and is not intended to limit the embodiments of the subject matter, or the application and uses of such embodiments. Any implementation described herein as exemplary is not to be construed as preferred or advantageous over other implementations. Rather, the term "exemplary" is used in the sense of example or "illustrative," rather than "ideal." The terms "comprise," "include," "have," "with," and any variations thereof are used synonymously to denote or describe a non-exclusive inclusion. As such, a device or a method that uses such terms does not include only those elements or steps, but may include other elements and steps not expressly listed or inherent to such device or method. Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. Moreover, the terms "a" and "an" herein do not denote a limitation of quantity, but rather denote the presence of at least one of the referenced item.

In this disclosure, the term "region" is used generally to refer to one or more layers. That is, a region (as used herein) may include a single layer (deposit, film, coating, etc.) of material or multiple layers of materials stacked on top of one another (i.e., a multi-layer structure). Further, although in the description below, the different regions and/or layers in the disclosed magnetoresistive devices may be referred to by specific names (e.g., first electrode, second electrode, first intermediate layer, second intermediate layer, fixed region, free region, etc.), this is only for ease of description and not intended as a functional description or relative location/orientation of the layer. Moreover, although the description below and the figures appear to depict a certain orientation of the layers relative to each other, those of ordinary skill in the art will understand that such descriptions and depictions are only exemplary. For example, though a certain first region may be depicted as being "below" a certain second region, in some aspects the entire depicted region may be flipped such that the first region is "above" the second region.

For the sake of brevity, conventional techniques related to semiconductor processing may not be described in detail herein. The exemplary embodiments may be fabricated using any suitable now-known or future-developed processes, such as known lithographic processes. The fabrication of integrated circuits, microelectronic devices, micro electro mechanical devices, microfluidic devices, and photonic devices involves the creation of several layers or regions (e.g., comprising one or more layers) of materials that interact in some fashion. One or more of these regions may be patterned so various regions of the layer have different electrical or other characteristics, which may be interconnected within the region or to other regions to create electrical components and circuits. These regions may be created by selectively introducing or removing various materials.

The patterns that define particular regions of devices according to the present disclosure are often created by lithographic processes. For example, a layer of photoresist may be applied onto a layer overlying a wafer substrate. A photo mask (containing clear and opaque areas) may be used to selectively expose the photoresist by a form of radiation, such as ultraviolet light, electrons, or x-rays. Either the photoresist exposed to the radiation, or not exposed to the radiation, may be removed by the application of a developer. An etch may then be employed/applied whereby the layer (or material) not protected by the remaining resist is patterned. Alternatively, an additive process can be used in which a structure is built up using the photoresist as a template.

Magnetoresistive devices of the current disclosure may include magnetic tunnel junction bits (MTJ bits, or MTJs). The MTJ bits may be formed from a magnetoresistive stack/structure that may include, or may be operably coupled to, one or more electrically conductive electrodes, vias, or conductors on either side of the magnetoresistive stack/structure. The magnetoresistive stack/structure that forms the MTJ bits may include many different regions and/or layers of material, where some of the regions and/or layers include magnetic materials, and whereas other regions and/or layers do not. In at least one embodiment, the methods of manufacturing the disclosed devices may include sequentially depositing, growing, sputtering, evaporating, and/or providing (collectively referred herein as "depositing" or other verb tense (e.g., "deposit" or "deposited")) layers and regions which, after further processing (for example, etching), form an MTJ bit (or a plurality of MTJ bits stacked one on top of another or arranged in an array).

As is known in the art, an electrical resistance of the described MTJ bits may change based on whether the magnetization direction (e.g., the direction of the magnetic moment) of a free region adjacent to a non-magnetic layer (e.g., a dielectric layer serving as a tunnel barrier) is in a parallel alignment or in an antiparallel alignment with the magnetization direction (e.g., the direction of the magnetic moment) of a fixed region adjacent to the non-magnetic layer. Typically, if the two regions have the same magnetization alignment, the resulting relatively low resistance is considered as a digital "0," while, if the alignment is antiparallel, the resulting relatively higher resistance is considered to be a digital "1." A memory device (such as an MRAM) may include multiple such MTJ bits, which may be referred to as memory cells or elements, arranged in an array of columns and rows. By measuring the current through each cell, the resistance of each cell, and thus the data stored in the memory array, can be read.

For memory devices (e.g., MRAM device), higher bit error rate (BER) at high time 0 (e.g., before any cycling) may be negative in general. Error correction code (ECC) may be used to mitigate BER, and a higher BER at time 0 may require greater amounts of ECC, which may be problematic to implement for chip design purposes due to limited surface area and other design reasons. For example, for distributed memory in a configuration bit for a field programmable gate array (FPGA) approach, the opportunity to efficiently apply ECC for a higher BER (e.g., at high time 0) may be even more limited. Accordingly, for efficient operation of a memory device, it may be desirable to reduce BER while simultaneously reducing reliance on using ECC for achieving the same.

One or more embodiments of the present disclosure may implement suppression of hard shorts and low magnetoresistive (MR) bits, while maintaining or improving circuit characteristics and cycling endurance by improving raw BER at high time 0. For example, because an MRAM bitcell may operatively have a logic state of 0 or 1 by driving current across a tunnel barrier (e.g., one or more layers of magnesium oxide (MgOₓ)), each logic state may be associated with certain resistance levels. If a short is present in a tunnel barrier, the respective resistance levels, including magnetoresistance levels, associated with each logic state may be too low to determine. In other words, if the magnetoresistance levels are too low due to a presence of a short in a tunnel barrier, the resistance delta between the logic 0 and 1 may become difficult to determine.

One or more embodiments may implement suppression of hard shorts and low MR bits without significantly increasing resistance-area product (RA) of an MTJ and while maintaining or improving other circuit characteristics and cycling endurance. Simply increasing the RA of the MTJ may suppress hard shorts and low MR bits, but may introduce unwanted side effects. Hard shorts and low MR bits may be correlated to oxidation time when forming a tunnel barrier of a magnetoresistive stack. For example, oxidation time may be increased arbitrarily, which may lead to an increase in the RA of the MTJ, suppressing hard shorts and low MR bits. However, the increased RA may introduce unwanted side effects as discussed above. For example, the increase in RA may increase the voltage to write (Vwrite) requirement of an MTJ bit. A higher Vwrite may cause limitations to the circuit design for example, and may also be negative for intrinsic cycling endurance. Therefore, it may be more optimal to increase oxidation time of a tunnel barrier while maintaining, or without significantly increasing, the RA for the MTJ.

In the context outlined above, one or more embodiments may include an interfacial layer including cobalt (Co) in a magnetoresistive stack. Inclusion of the interfacial layer including cobalt (Co) may allow an increase in oxidation time of a tunnel barrier while maintaining or without significantly increasing the RA. The interfacial layer may be disposed in the magnetoresistive stack between a reference layer and an intermediate layer (e.g., dielectric layer including a tunnel barrier). Additionally, one or more embodiments may describe exemplary fabrication processes for manufacturing a MRAM device, where a delay of time may be introduced after various magnesium (Mg) deposition stages and before corresponding oxidation stages for a tunnel barrier in an intermediate layer. The delay of time may be introduced in or may be compatible with various environments after a respective magnesium (Mg) deposition stage, such as environments with low oxygen partial pressure.

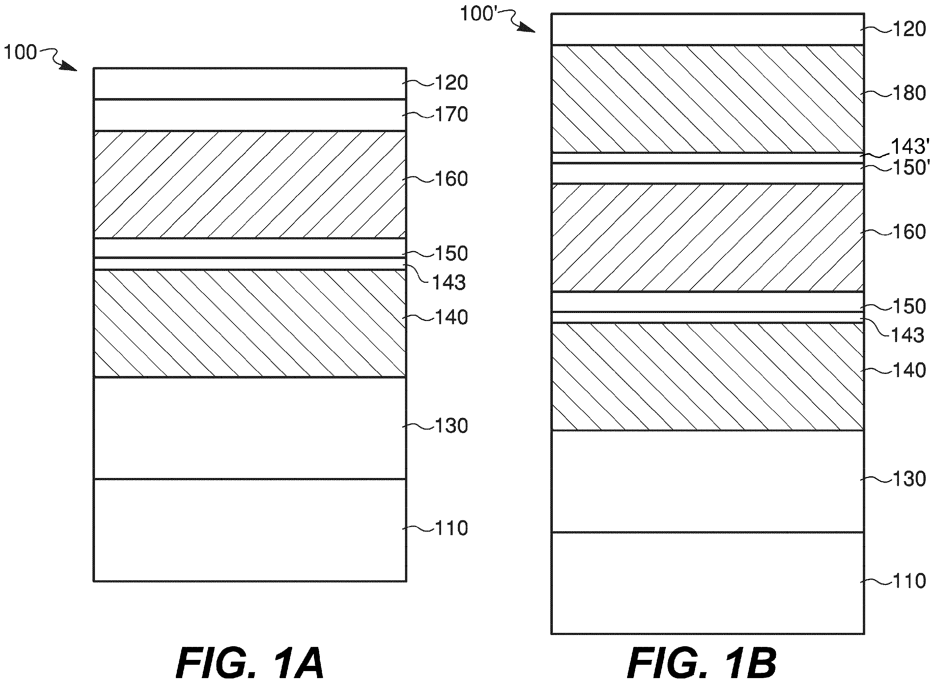

Referring now to the drawings, FIGS. 1A and 1B illustrate cross-sectional views depicting various regions of exemplary magnetoresistive stacks, according to one or more embodiments of the present disclosure. In FIG. 1A, an exemplary magnetoresistive stack 100 is shown, including a fixed magnetic region 140 and a free magnetic region 160 disposed between a first electrode 110 (e.g., a via or other conductor) and a second electrode 120 (e.g., a via or other conductor). A seed region 130 may be disposed between the first electrode 110 and fixed region 140. Magnetoresistive stack 100 may include an intermediate layer 150 (e.g., of a dielectric material) disposed between the fixed region 140 and the free region 160. The intermediate layer 150 may include a tunnel barrier. Magnetoresistive stack 100 may further include an interfacial layer 143 including cobalt (Co), which may be disposed between the fixed region 140 and the intermediate layer 150. In one embodiment, the interfacial layer 143 may consist of cobalt (Co). The interfacial layer 143 may operate as an interface between the fixed region 140 and the intermediate layer 150. The interfacial layer 143 may be disposed on and in contact with the fixed region 140. The intermediate layer 150 may be disposed on and in contact with the interfacial layer 143. A spacer region 170 may be disposed between the free region 160 and the second electrode 120.

In some embodiments, a seed region 130 may be formed directly on or above top first electrode 110. The seed region 130 may act as a surface on which one or more layers of a fixed region 140 may be formed (e.g., directly or indirectly) and allows current to pass bidirectionally from the first electrode 110 to the fixed region 140. The seed region 130 may include one or more of nickel (Ni), chromium (Cr), cobalt (Co), iron (Fe), or alloys thereof. In some embodiments, the seed region 130 may include an alloy including nickel (Ni) and chromium (Cr), such as, e.g., a NiCr alloy. The seed region 130 may further include one or more other metals or metal alloys, such as, by way of non-limiting example, palladium (Pd), platinum (Pt), nickel (Ni), tantalum (Ta), ruthenium (Ru), tungsten (W), molybdenum (Mo), iron-boron (FeB), cobalt-iron-boron (CoFeB), tantalum-nitride (TaN), or combinations thereof.

Referring to FIG. 1B, another exemplary magnetoresistive stack 100' is shown, including a first fixed magnetic region 140, a free magnetic region 160, and a second fixed magnetic region 180 disposed between a first electrode 110 (e.g., a via or other conductor) and a second electrode 120 (e.g., a via or other conductor). A seed region 130 may be disposed between the first electrode and the first fixed region 140. Magnetoresistive stack 100' may include a first intermediate layer 150 (e.g., made of a dielectric material) disposed between the first fixed region 140 and the free region 160 and a second intermediate layer 150' (e.g., also made of a dielectric material) above the free region 160. The first intermediate layer 150 and/or the second intermediate layer 150' may include a tunnel barrier. Magnetoresistive stack 100' may further include an interfacial layer 143 including cobalt (Co), which may be disposed between the fixed region 140 and the first intermediate layer 150. The interfacial layer 143 may operate as an interface between the fixed region 140 and the first intermediate layer 150. The interfacial layer 143 may assist in maintaining or lowering the RA of the MTJ of the magnetoresistive stack 100', and/or preventing the RA of the MTJ of the magnetoresistive stack 100' from significantly increasing when, for example, oxidation time of the tunnel barrier is increased. The interfacial layer 143 may be disposed on and in contact with the fixed region 140. The first intermediate layer 150 may be disposed on and in contact with the interfacial layer 143. In some embodiments, the magnetoresistive stack 100' may include a second interfacial layer 143' including cobalt (Co), or a Co-based alloy, between the second intermediate layer 150' and the second fixed magnetic region 180. The second interfacial layer 143' may assist in maintaining or lowering the RA of the MTJ of the magnetoresistive stack 100', and/or preventing the RA of the MTJ of the magnetoresistive stack 100' from significantly increasing when, for example, oxidation time of the tunnel barrier is increased. The second interfacial layer 143' may operate as an interface between the second fixed magnetic region 180 and the second intermediate layer 150'.

An embodiment including two fixed magnetic regions, such as stack 100', may be referred to more commonly as a dual spin filter (DSF) magnetoresistive stack/structure. In some embodiments, the magnetoresistive stack 100' may optionally include a spacer region (not pictured in FIG. 1B) to replace the second fixed region 180 and/or between the second intermediate layer 150' and the second electrode 120.

In one or more embodiments, fixed region 140 may be a fixed, unpinned synthetic antiferromagnet (SAF) multilayer structure disposed on seed region 130. The fixed, unpinned SAF multilayer structure may include two magnetic regions (e.g., made of one or more layers) separated by a coupling layer according to one example. Each magnetic region may include nickel (Ni), iron (Fe), and cobalt (Co), palladium (Pd), platinum (Pt), chromium (Cr), manganese (Mn), magnesium (Mg), and alloys or combinations thereof. The coupling layer may be an antiferromagnetic coupling layer that includes non-ferromagnetic materials such as, for example, iridium (Ir), ruthenium (Ru), rhenium (Re), or rhodium (Rh). In some embodiments, one or more magnetic regions may include a magnetic multilayer structure that includes a plurality of layers of a first ferromagnetic material (e.g., cobalt (Co)), a second ferromagnetic material (e.g., nickel (Ni)), and/or a paramagnetic material (e.g., platinum (Pt)).

Additionally, or in the alternative, in some embodiments, the fixed region 140 may include one or more synthetic ferromagnetic structures (SyF). Since SyFs are known to those skilled in the art, they are not described in greater detail herein. In some embodiments, the fixed region 140 may have a thickness of approximately 8 angstroms (Å) to approximately 300 Å, approximately 15 Å to approximately 110 Å, greater than or equal to 8 Å, greater than or equal to 15 Å, less than or equal to 300 Å, or less than or equal to 110 Å.

The interfacial layer 143 may include cobalt (Co). The interfacial layer 143 may be disposed on and in contact with a reference layer (discussed in detail with respect to the later figures) of the fixed region 140. The interfacial layer 143 may have a thickness ranging from approximately 0.5 Å to approximately 5 Å and preferably from approximately 1 Å to approximately 3 Å.

The intermediate layer 150 may include a tunnel barrier as discussed above, and the tunnel barrier may contain several layers of an oxidized material to form a single tunnel barrier. The intermediate layer 150 may have a thickness ranging from approximately 3 Å to approximately 25 Å, and preferably from approximately 5 Å to approximately 20 Å, and more preferably from approximately 8 Å to approximately 15 Å. In various examples, the tunnel barrier may contain magnesium oxide (MgOₓ). The deposition and fabrication process for the tunnel barrier may involve individually depositing and oxidizing one or more layers of oxidizable material, where a delay of time may be introduced between an individual deposition and oxidization step for a respective layer. This deposition and fabrication process will be discussed in greater detail with respect to the later figures.

Fixed region 140 and the interfacial layer 143 may be deposited using any technique now known or later developed. In some embodiments, one or more of the magnetic regions of the fixed region 140 may be deposited using a "heavy" inert gas (e.g., xenon (Xe), argon (Ar), krypton (Kr)), at room temperature, approximately 25°C, approximately 15°C to approximately 40°C, approximately 20°C to approximately 30°C. In some embodiments, the coupling layer of the SAF may also be deposited using a "heavy" inert gas at similar temperatures. In some embodiments, one or more of the magnetic regions of the fixed region 140 may be deposited using a "heavy" inert gas (e.g., xenon (Xe), argon (Ar), krypton (Kr)), at temperatures greater than approximately 25°C, such as, for example, greater than approximately 150°C.

The various regions or layers of fixed region 140 may be deposited individually during manufacture. However, as would be recognized by those of ordinary skill in the art, the materials that make up the various regions may alloy with (intermix with and/or diffuse into) the materials of adjacent regions during subsequent processing (e.g., deposition of overlying layers, high temperature or reactive etching technique, and/or annealing). Therefore, a person skilled in the art would recognize that, although the different regions of fixed region 140 may appear as separate regions with distinct interfaces immediately after formation of these regions, after subsequent processing operations, the materials of the different layers or regions may alloy together to form a single alloyed fixed region 140 having a higher concentration of different materials at interfaces between different regions. Thus, in some cases, it may be difficult to distinguish the different regions of the fixed region 140 in a finished magnetoresistive stack.

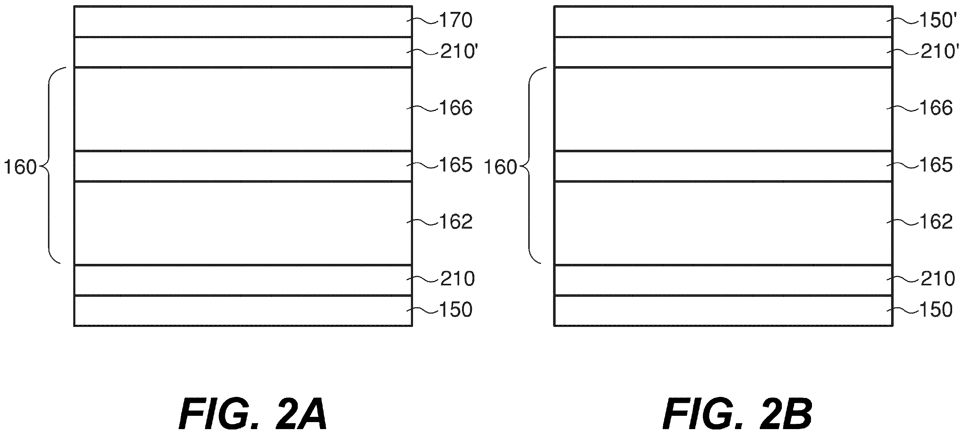

Referring now to FIGS. 2A and 2B, in one or more embodiments, free region 160 may include one or more layers of ferromagnetic material (e.g., first ferromagnetic region 162 and/or second ferromagnetic region 166) separated by a coupling layer 165 (e.g., including tantalum (Ta), tungsten (W), molybdenum (Mo), ruthenium (Ru), rhodium (Ro), rhenium (Re), iridium (Ir), chromium (Cr), osmium (Os), vanadium (V), and combinations thereof). The coupling layer 165 may provide either ferromagnetic coupling or antiferromagnetic coupling between the ferromagnetic layers/regions of the free magnetic region 160. Notwithstanding the specific construction of free magnetic region 160, free magnetic region 160 may include a magnetic vector (or moment) that can be moved or switched by applied magnetic fields or spin transfer torque. Free magnetic region 160 may be formed from any ferromagnetic material or alloy having two or more stable magnetic states. Additional elements may be added to the ferromagnetic material or alloy to provide improved magnetic, electrical, or microstructural properties. In some embodiments, free region 160 also may include one or more synthetic anti-ferromagnetic (SAF) or synthetic ferromagnet (SyF) structures. In some embodiments, as depicted in FIG. 2A, a free region 160 may be disposed between an intermediate layer 150 and a spacer region 170 (or second electrode 120). In other embodiments, such as the one shown in FIG. 2B, a free region 160 may be disposed between a first intermediate layer 150 and a second intermediate layer 150'. The layers of free region 160 may be formed by any process described herein, such as, for example, physical vapor deposition (PVD) or chemical vapor deposition (CVD) process known in the art (e.g., sputtering, magneton sputtering, ion beam deposition, atomic layer deposition, evaporative techniques).

One or more insertion layers 210 may be disposed on either side of free region 160. For example, referring to FIG. 2A, a first insertion layer 210 may be disposed between intermediate layer 150 and free region 160. Alternatively or in addition, a second insertion layer 210' may be disposed between free region 160 and spacer region 170 (or second electrode 120). Referring to FIG. 2B, in some embodiments, a first insertion layer 210 may be formed between a first intermediate layer 150 and free region 160 and/or a second insertion layer 210' may be formed between free region 160 and a second intermediate layer 150'.

In some embodiments, the one or more layers of ferromagnetic material (e.g., first ferromagnetic region 162 and/or second ferromagnetic region 166) of free region 160 may include nickel (Ni), iron (Fe), cobalt (Co), iridium (Ir), ruthenium (Ru), boron (B), tantalum (Ta), tungsten (W), molybdenum (Mo), and/or alloys comprising nickel (Ni), iron (Fe), cobalt (Co), iridium (Ir), ruthenium (Ru), boron (B), tantalum (Ta), tungsten (W), and/or molybdenum (Mo). One or more layers of ferromagnetic material (e.g., first ferromagnetic region 162 and/or second ferromagnetic region 166) may include one or more alloys that include iron (Fe), cobalt (Co), or nickel (Ni), and other relatively electronegative elements (e.g., elements with an electronegativity greater than the electronegativity of iron (Fe)). For example, the one or more layers of ferromagnetic material may include one or more alloys, such as, for example, an alloy having the formula XY, where X is selected from a list comprising: cobalt (Co), iron (Fe), nickel (Ni), cobalt-iron (CoFe), iron-nickel (FeNi), and cobalt-nickel (CoNi), and Y is selected from a list comprising: silicon (Si), copper (Cu), rhenium (Re), tin (Sn), boron (B), molybdenum (Mo), ruthenium (Ru), palladium (Pd), osmium (Os), iridium (Ir), rhodium (Rh), platinum (Pt), tungsten (W), and carbon (C). Inclusion in the alloy of one or more elements, that have an electronegativity greater than the electronegativity of iron (Fe) (e.g., silicon (Si), copper (Cu), rhenium (Re), tin (Sn), boron (B), molybdenum (Mo), ruthenium (Ru), palladium (Pd), osmium (Os), iridium (Ir), rhodium (Rh), platinum (Pt), tungsten (W), carbon (C)), into the free region 160 may allow for a longer oxidation time to be used in forming the intermediate layer 150 without oxidation of the one or more layers of ferromagnetic material. The inclusion of such metals that have a greater electronegativity than the electronegativity of iron (Fe) may also facilitate greater stability of the stack during annealing and/or other processing steps.

The one or more layers of ferromagnetic material (e.g., first ferromagnetic region 162 and/or second ferromagnetic region 166) may have a thickness of approximately 10 Å to approximately 40 Å, approximately 20 Å to approximately 30Å, or approximately 25 Å to approximately 28.5 Å. In such embodiments, the one or more insertion layers 210, 210' may include nickel (Ni), cobalt (Co), boron (B), ruthenium (Ru), iridium (Ir), or a combination thereof.

Insertion layers 210, 210' may further comprise iron (Fe), alloys including cobalt (Co) and iron (Fe), alloys including nickel (Ni) and iron (Fe), and/or alloys including two or more of cobalt (Co), nickel (Ni), iron (Fe), and boron (B).

In some embodiments, an insertion layer 210, 210' may include more than or equal to 50 at.% iron (Fe), more than or equal to 60 at.% iron (Fe), more than or equal to 65 at.% iron (Fe), more than or equal to 70 at.% iron (Fe), more than or equal to 75 at.% iron (Fe), more than or equal to 80 at.% iron (Fe), more than or equal to 85 at.% iron (Fe), more than or equal to 90 at.% iron (Fe), more than or equal to 95 at.% iron (Fe), more than or equal to 97 at.% iron (Fe), or even more than or equal to 99 at.% iron (Fe). In some embodiments, an insertion layer 210, 210' may comprise less than or equal to 50 at.% cobalt (Co), less than or equal to 55 at.% cobalt (Co), less than or equal to 65 at.% cobalt (Co), less than or equal to 70 at.% cobalt (Co), less than or equal to 75 at.% cobalt (Co), less than or equal to 80 at.% cobalt (Co), less than or equal to 85 at.% cobalt (Co), less than or equal to 90 at.% cobalt (Co), or less than or equal to 95 at.% cobalt (Co). In further embodiments, an insertion layer 210, 210' may comprise greater than or equal to 50 at.% nickel (Ni), greater than or equal to 55 at.% nickel (Ni), greater than or equal to 65 at.% nickel (Ni), greater than or equal to 70 at.% nickel (Ni), greater than or equal to 75 at.% nickel (Ni), greater than or equal to 80 at.% nickel (Ni), greater than or equal to 85 at.% nickel (Ni), greater than or equal to 90 at.% nickel (Ni), or greater than or equal to 95 at.% nickel (Ni).

In some embodiments, one or more insertion layers 210, 210' may include a high-iron content layer (e.g., an iron interface layer). In such embodiments, first ferromagnetic region 162 and/or second ferromagnetic region 166 may include greater than or equal to 50 at.% of one or more of nickel (Ni), cobalt (Co), ruthenium (Ru), iridium (Ir), or combinations thereof. First ferromagnetic region 162 and/or second ferromagnetic region 166 may further include iron (Fe). The iron-content of first ferromagnetic region 162 and/or second ferromagnetic region 166 may be less than or equal to approximately 50 at.%, less than or equal to approximately 40 at.%, less than or equal to approximately 35 at.%, less than or equal to approximately 30 at.%, less than or equal to approximately 25 at.%, less than or equal to approximately 20 at.%, less than or equal to approximately 15 at.%, less than or equal to approximately 10 at.%, approximately 5 at.% to approximately 40 at.%, or approximately 15 at.% to approximately 30 at.%. In said embodiments, first ferromagnetic region 162 may have a thickness of approximately 6 Å to approximately 11 Å, such as, for example, 6.5 Å to 10 Å or 7.5 Å to 9Å. Further, second ferromagnetic region 166 may have a thickness of approximately 1.5 Å to approximately 9 Å, such as, for example, 1.5 Å to 7 Å or 2.5 Å to 4.5 Å.

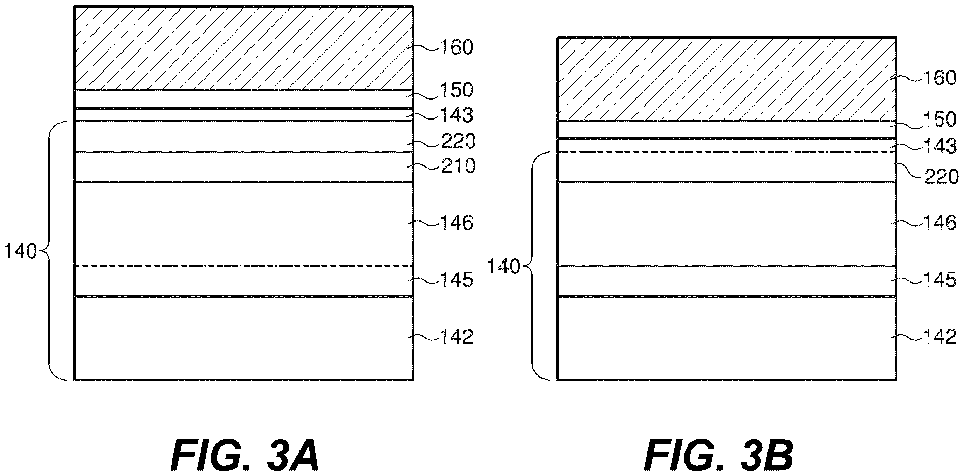

Referring now to FIGS. 3A and 3B, in some embodiments, the fixed region or regions (e.g., fixed regions 140, 180 depicted in FIGS. 1A and 1B) may include one or more layers. While FIGS. 3A and 3B depict only fixed region 140, the aspects of fixed region 140 may also apply to fixed region 180 depicted in FIG. 1B. As depicted in FIGS. 3A and 3B, fixed region 140 may include, or may be disposed adjacent to, one or more additional layers, such as, e.g., an insertion layer 210 and/or a reference layer 220. The insertion layer 210 and/or reference layer 220 may be disposed at the top of fixed region 140, proximate to an overlying layer (e.g., interfacial layer 143).

Reference layer 220 may include one or more layers of material that, among other things, facilitate and improve the growth of one or more overlying regions during manufacture of magnetoresistive stack 100 and 100'. The reference layer 220 may include, e.g., cobalt (Co), iron (Fe), and boron (B), such as a cobalt-iron-boron alloy (CoFeB), a cobalt-iron-boron-tantalum allow (CoFeBTa), a cobalt-iron-tantalum alloy (CoFeTa), or combinations thereof. In some embodiments, reference layer 220 may include one or more alloys that include iron (Fe), cobalt (Co) or nickel (Ni), and other relatively electronegative elements (e.g., elements with an electronegativity greater than the electronegativity of iron (Fe)). For example, the reference layer 220 may include one or more alloys, such as, for example, an alloy having the formula XY, where X is selected from a list comprising: cobalt (Co), iron (Fe), nickel (Ni), cobalt-iron (CoFe), iron-nickel (FeNi), and cobalt-nickel (CoNi), and Y is selected from a list comprising: silicon (Si), copper (Cu), rhenium (Re), tin (Sn), boron (B), molybdenum (Mo), ruthenium (Ru), palladium (Pd), osmium (Os), iridium (Ir), rhodium (Rh), platinum (Pt), tungsten (W), and carbon (C). Inclusion in the alloy of one or more elements, that have an electronegativity greater than the electronegativity of iron (Fe) (e.g., silicon (Si), copper (Cu), rhenium (Re), tin (Sn), boron (B), molybdenum (Mo), ruthenium (Ru), palladium (Pd), osmium (Os), iridium (Ir), rhodium (Rh), platinum (Pt), tungsten (W), carbon (C)), into the reference layer 220 may allow for a longer oxidation time to be used in forming the intermediate layer 150 without oxidation of the fixed region 140. The inclusion of such metals that have a greater electronegativity than the electronegativity of iron (Fe) may also facilitate greater stability of the stack during annealing and/or other processing steps.

In one or more embodiments, a fixed region 140 may include a first magnetic region 142, a coupling layer 145, a second magnetic region 146, an insertion layer 210, and/or a reference layer 220. The first magnetic region 142 may include one or more layers of magnetic or ferromagnetic material. In some embodiments, each layer of magnetic or ferromagnetic material has a thickness less than or equal to approximately 10 Å, less than or equal to approximately 8 Å, less than or equal to approximately 6 Å, less than or equal to approximately 5 Å, less than or equal to approximately 4 Å, less than or equal to approximately 3 Å, or approximately 1 Å to approximately 6 Å.

A coupling layer 145 may be disposed above and/or in contact with the first magnetic region 142. A second magnetic region 146 may be disposed on coupling layer 145. The second magnetic region 146 may have the same composition as the first magnetic region 142, or the second magnetic region 146 may have a different composition than the first magnetic region 142. In some embodiments, a layer of cobalt (Co) is formed on the coupling layer 145 as part of the second magnetic region 146. The coupling layer 145 may be disposed between two cobalt (Co) layers-e.g., between a cobalt layer in first magnetic region 142 and a cobalt layer in second magnetic region 146.

Referring to FIG. 3A, in one or more embodiments, an insertion layer 210, with a composition as previously described (e.g., with respect to insertion layers 210, 210' depicted in FIGS. 2A and 2B), may be disposed adjacent to second magnetic region 146. A reference layer 220 may be adjacent to insertion layer 210. In some embodiments, as shown in FIG. 3B, fixed region 140 may not include an insertion layer 210, and reference layer 220 may be disposed adjacent to second magnetic region 146. Reference layer 220 may include cobalt-iron-boron (CoFeB) or other compositions with a high cobalt (Co) content. For example, reference layer 220 may comprise greater than or equal to approximately 50 at.% cobalt (Co), greater than or equal to approximately 55 at.% cobalt (Co), greater than or equal to approximately 65 at.% cobalt (Co), greater than or equal to approximately 70 at.% cobalt (Co), greater than or equal to approximately 75 at.% cobalt (Co), greater than or equal to approximately 80 at.% cobalt (Co), greater than or equal to approximately 85 at.% cobalt (Co), greater than or equal to approximately 90 at.% cobalt (Co), or greater than or equal to approximately 95 at.% cobalt (Co).

An interfacial layer 143 including cobalt (Co) may be disposed on and in contact with the reference layer 220 as depicted in FIGS. 3A and 3B. The interfacial layer 143 may be disposed between the reference layer 220 and the intermediate layer 150. In one embodiment, the interfacial layer 143 including cobalt (Co) may replace or supplement materials such as cobalt-iron-boron (CoFeB) found in the reference layer 220.

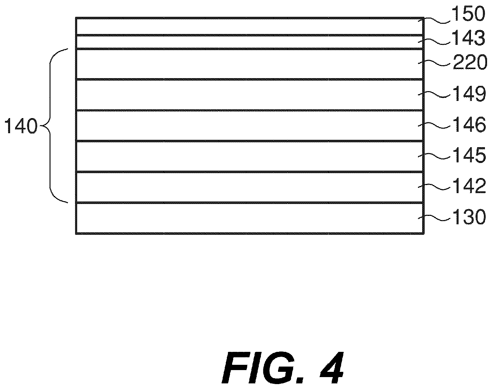

Referring now to FIG. 4, a fixed magnetic region 140 (e.g., a SAF within fixed magnetic region 140) may include a transition layer 149 disposed above second magnetic region 146 and below reference layer 220. Transition layer 149 may be in contact with second magnetic region 146 and/or reference layer 220. Transition layer 149 may include a non-ferromagnetic transition metal, such as, for example, tantalum (Ta), titanium (Ti), tungsten (W), molybdenum (Mo), or combinations and alloys thereof.

Exemplary methods for forming a magnetoresistive stack 100 and 100' according to embodiments of the present disclosure will now be discussed, and reference to parts and the numbered labels shown in FIGS. 1-4 may be made.

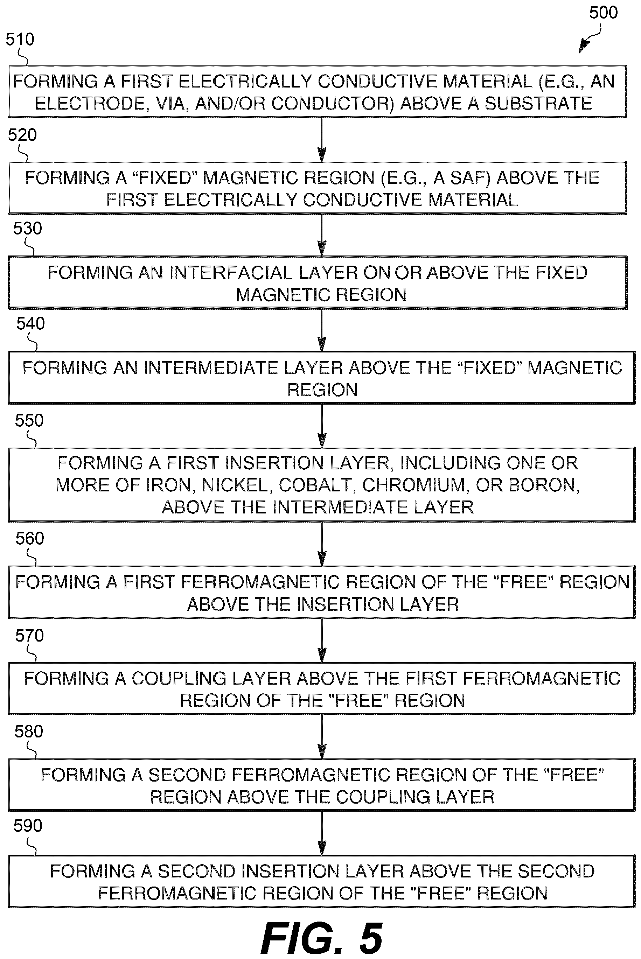

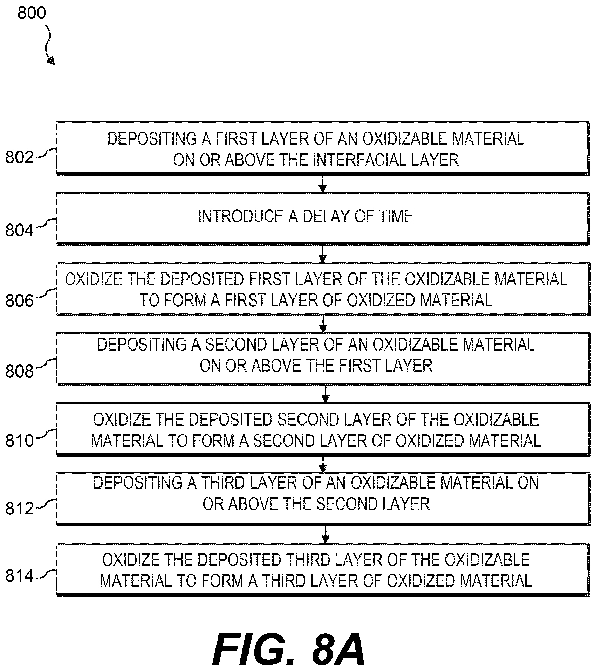

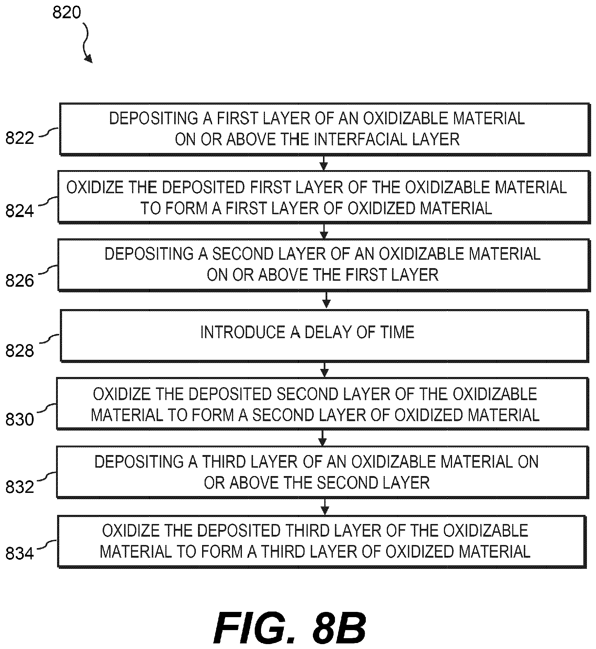

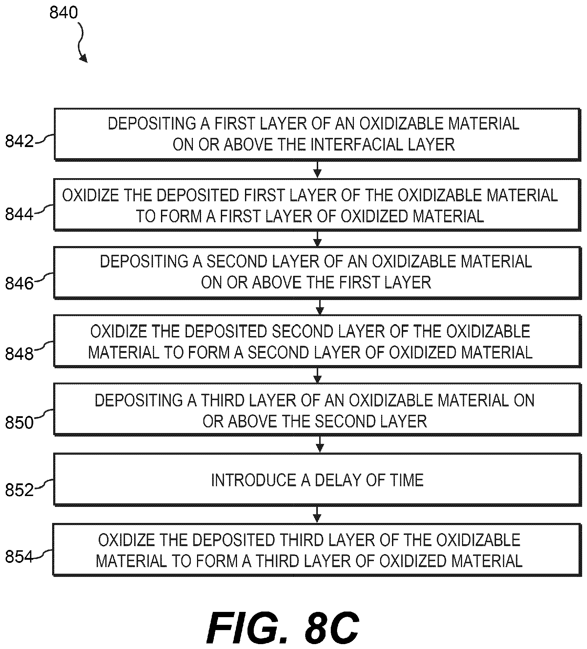

FIG. 5 is a flowchart of a method 500 of manufacturing a magnetoresistive stack 100, according to the present disclosure. A first electrically conductive material 110 (e.g., an electrode, via, and/or conductor) may be formed above a substrate, such as, for example, a silicon-based substrate (step 510). A fixed magnetic region (e.g., a SAF) 140 may then be formed above the first electrically conductive material 110 (step 520). An interfacial layer 143 including cobalt (Co) may be formed on or above the fixed magnetic region 140 (step 530). In one or more embodiments, the interfacial layer 143 may be formed on and in contact with the reference layer 220 of the fixed magnetic region 140. An intermediate layer 150 (e.g., a dielectric layer including a tunnel barrier) may be formed above the fixed magnetic region 140 (step 540). In one or more embodiments, the intermediate layer 150 may be formed above and/or in contact with the interfacial layer 143. The interfacial layer 143 may be disposed between the intermediate layer 150 and the fixed magnetic region 140. The intermediate layer 150, in various embodiments, may include magnesium oxide (MgOₓ). Formation of the intermediate layer 150 will be discussed in greater detail with respect to the flowcharts depicted in FIGS. 8A-8C.

A first insertion layer 210, (which may, in some embodiments, include one or more of iron (Fe), nickel (Ni), cobalt (Co), chromium (Cr), or boron (B)), may be formed above the intermediate layer 150 (step 550). As discussed above in reference to FIGS. 2A-2B, the insertion layer may be formed above the intermediate layer 150. A first ferromagnetic region 162 of free magnetic region 160 may be formed over the insertion layer 210 (step 560). A coupling layer 165 may be formed above the first ferromagnetic region 162 (step 570). A second ferromagnetic region 166 of the free region 160 may be formed above the coupling layer 165 (step 580). A second insertion layer 210', (e.g., including one or more of iron (Fe), nickel (Ni), cobalt (Co), chromium (Cr), or boron (B)), may be formed above the second ferromagnetic region 166 (step 590). After the free magnetic region 160 is formed, an optional spacer region may be formed above the free magnetic region 160 in some embodiments. In some embodiments, a second intermediate layer may be formed above and/or in contact with the free region 160. In some embodiments, a second electrically conductive material 120 (e.g., an electrode, via, and/or conductor) may be formed above the spacer region, thereby providing electrical connectivity to magnetoresistive stack 100.

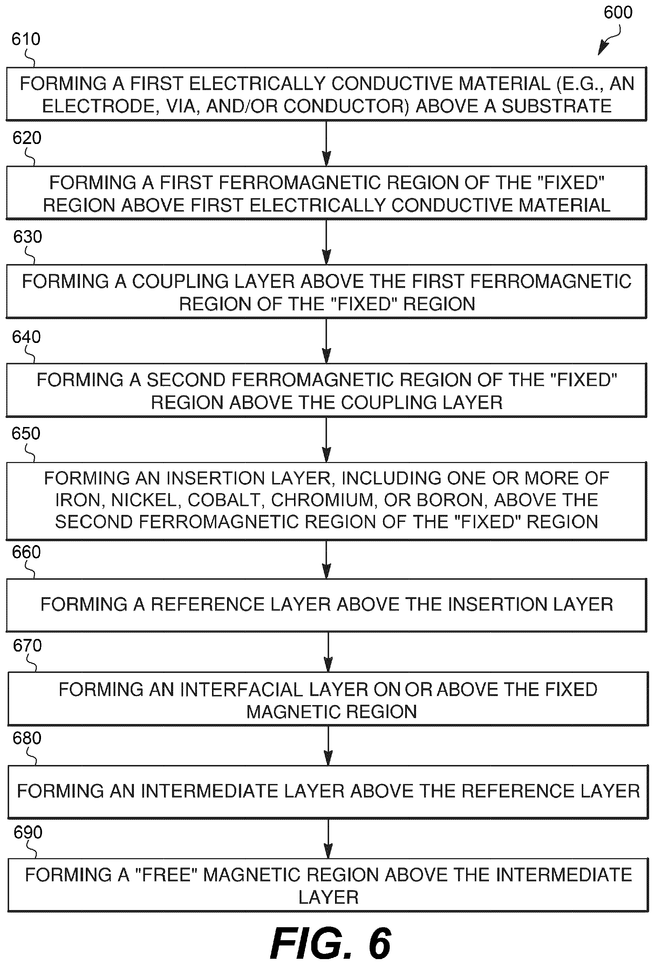

FIG. 6 is a flowchart of another method 600 of manufacturing a magnetoresistive stack 100', according to the present disclosure. A first electrically conductive material 110 (e.g., an electrode, via, and/or conductor) may be formed above a substrate, such as, for example, a silicon-based substrate (step 610). A first ferromagnetic region 142 may be formed above the first electrically conductive material 110 (step 620). A coupling layer 145 may be formed above the first ferromagnetic region 142 (step 630). A second ferromagnetic region 146 may be formed above coupling layer 145 (step 640). An insertion layer 210 (which may, in some embodiments, include one or more of nickel (Ni), cobalt (Co), iron (Fe), chromium (Cr), or boron (B)) may be formed above the second ferromagnetic region 146 of the fixed region 140 (step 650). A reference layer 220 may be formed above and in contact with insertion layer 210 (step 660).

An interfacial layer 143 including cobalt (Co) may be formed on or above the fixed magnetic region 140 (step 670). In one or more embodiments, the interfacial layer 143 may be formed on and in contact with the reference layer 220 of the fixed magnetic region 140. An intermediate layer 150 (e.g., a dielectric intermediate layer including a tunnel barrier) may be formed above reference layer 220 of the fixed magnetic region 140 (step 680). In one or more embodiments, the intermediate layer 150 may be formed above and/or in contact with the interfacial layer 143. The interfacial layer 143 may be disposed between the intermediate layer 150 and the fixed magnetic region 140. The intermediate layer 150, in various embodiments, may include magnesium oxide (MgOx). Formation of the intermediate layer 150 will be discussed in greater detail with respect to the flowcharts depicted in FIGS. 8A-8C.

A free magnetic region 160 may be formed above the intermediate layer 150 (step 690). After the free magnetic region 160 is formed, a second intermediate layer 150' may be formed above the free magnetic region 160. A second fixed magnetic region 180 may then be formed above the second intermediate layer 150'. In some embodiments, an optional spacer region 170 may be formed to replace the second fixed region 180. A second electrically conductive material 120 (e.g., an electrode, via, and/or conductor) may also be formed above the second fixed region 180, thereby providing electrical connectivity to magnetoresistive stack 100'.

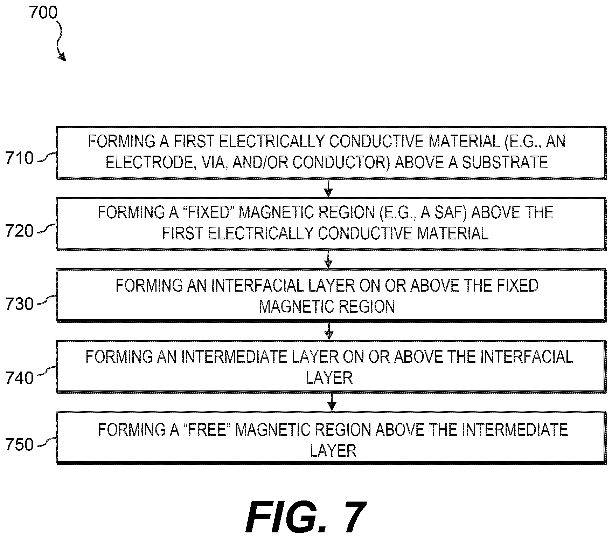

FIG. 7 is a flowchart of a method 700 of manufacturing magnetoresistive stacks 100 and/or 100', according to the present disclosure. The method 700 as described is not exhaustive, and the magnetoresistive stack 100 and 100' may include other regions or layers not described by method 700, as shown in FIGS. 1-6. At step 710, a first electrically conductive material 110 (e.g., an electrode, via, and/or conductor) may be formed above a substrate, such as, for example, a silicon-based substrate. At step 720, a fixed magnetic region (e.g., a SAF) 140 may then be formed above the first electrically conductive material 110, similar to as described with respect to step 520 (FIG. 5) and steps 620-660 (FIG. 6). At step 730, an interfacial layer 143 including cobalt (Co) may be formed on or above the fixed magnetic region 140 (e.g., as described in step 530). In one or more embodiments, the interfacial layer 143 may be formed on and in contact with the reference layer 220 of the fixed magnetic region 140. The interfacial layer 143 may have a thickness ranging from approximately 0.5 Å to approximately 5 Å, and preferably from approximately 0.8 Å to approximately 3 Å, and more preferably from approximately 1 Å to 2 Å.

At step 740, an intermediate layer 150 (e.g., a dielectric layer including a tunnel barrier) may be formed above and in contact with the interfacial layer 143. The interfacial layer 143 may be disposed between the intermediate layer 150 and the fixed magnetic region 140. The intermediate layer 150, in various embodiments, may include magnesium oxide (MgOₓ). Formation of the intermediate layer 150 will be discussed in greater detail with respect to the flowcharts depicted in FIGS. 8A-8C. At step 750, a free magnetic region 160 may be formed above the intermediate layer 150, similar to as described with respect to steps 560-580 (FIG. 5) and/or step 690 (FIG. 6).

FIGS. 8A-8C are flowcharts of various methods describing the process for forming intermediate layer 150 for magnetoresistive stacks 100 and/or 100', according to the present disclosure. As described above, the intermediate layer 150 may include a tunnel barrier containing magnesium oxide (MgOₓ). The magnesium oxide (MgOₓ) may be formed in a specialized way that can facilitate an increase in oxidation time while keeping RA for the MTJ approximately the same, leading to a lower BER for the magnetoresistive stacks 100 and/or 100'.

At step 802 for method 800, a first layer of an oxidizable material may be deposited on or above interfacial layer 143. The oxidizable material may include magnesium (Mg). At step 804, a delay of time may be introduced after the deposition of the first layer of the oxidizable material onto a wafer (e.g., for fabrication of the magnetoresistive stack 100 and or 100') but before oxidizing the first layer. For example, a delay of time may be introduced after the wafer including the first layer of the oxidizable material is inserted into an oxidation chamber but before any oxidation occurs. However, the scope of this disclosure is not limited in this manner, and a delay of time may be introduced in other ways (e.g., before being inserted into an oxidation chamber). As such, a delay of time as referenced herein may generally refer to an amount of time that has passed between a deposition process of a particular layer of an oxidizable material and a corresponding oxidation process of the particular layer of the oxidizable material. In one or more embodiments, the delay of time may range from approximately 1 minute to approximately 30 minutes, or from approximately 1 minute to approximately 25 minutes.

At step 806, the deposited first layer of the oxidizable material may be oxidized to form a first layer of oxidized material. The oxidation step may be performed with various oxidation techniques now known or later to be developed, such as oxygen plasma oxidation, thermal oxidation, oxygen radical oxidation, or natural oxidation by exposure to a low-pressure oxygen environment, among others.

At step 808, a second layer of an oxidizable material may be deposited on or above the first layer of the oxidized material. The oxidizable material may include magnesium (Mg). At step 810, the deposited second layer of the oxidizable material may be oxidized to form a second layer of oxidized material. At step 812, a third layer of an oxidizable material (e.g., magnesium (Mg)) may be deposited on or above the second layer of the oxidized material. At step 814, the deposited third layer of the oxidizable material may be oxidized to form a third layer of oxidized material. The first layer of the oxidized material, the second layer of the oxidized material, and the third layer of the oxidized material together may form an overall magnesium oxide (MgOₓ) tunnel barrier for the intermediate layer 150.

At step 822 for method 820, a first layer of an oxidizable material (e.g., magnesium (Mg)) may be deposited on or above interfacial layer 143. At step 824, the deposited first layer of the oxidizable material may be oxidized to form a first layer of oxidized material. Next, at step 826, a second layer of an oxidizable material (e.g., magnesium (Mg)) may be deposited on or above the first layer of the oxidized material. At step 828, a delay of time may be introduced after the deposition of the second layer of the oxidizable material onto the wafer on or above the first layer of the oxidized material (e.g., for fabrication of the magnetoresistive stack 100 and or 100') but before oxidizing the second layer. In one or more embodiments, the delay of time may range from approximately 1 minute to approximately 30 minutes or from approximately 1 minute to approximately 25 minutes. At step 830, the deposited second layer of the oxidizable material may be oxidized to form a second layer of oxidized material. The second layer of the oxidized material may be a middle layer of the tunnel barrier. At step 832, a third layer of an oxidizable material (e.g., magnesium (Mg)) may be deposited on or above the second layer of the oxidized material. At step 834, the deposited third layer of the oxidizable material may be oxidized to form a third layer of oxidized material. The first layer of the oxidized material, the second layer of the oxidized material, and the third layer of the oxidized material together may form an overall magnesium oxide (MgOₓ) tunnel barrier for the intermediate layer 150.

At step 842 for method 840, a first layer of an oxidizable material (e.g., magnesium (Mg)) may be deposited on or above interfacial layer 143. At step 844, the deposited first layer of the oxidizable material may be oxidized to form a first layer of oxidized material. Next, at step 846, a second layer of an oxidizable material (e.g., magnesium (Mg)) may be deposited on or above the first layer of the oxidized material. At step 848, the deposited second layer of the oxidizable material may be oxidized to form a second layer of oxidized material. At step 850, a third layer of an oxidizable material (e.g., magnesium (Mg)) may be deposited on or above the second layer of the oxidized material. At step 852, a delay of time may be introduced after the deposition of the third layer of the oxidizable material onto the wafer on or above the second layer of the oxidized material (e.g., for fabrication of the magnetoresistive stack 100 and or 100') but before oxidizing the third layer. In one or more embodiments, the delay of time may range from approximately 1 minute to approximately 30 minutes or from approximately 1 minute to approximately 25 minutes. At step 854, the deposited third layer of the oxidizable material may be oxidized to form a third layer of oxidized material. The first layer of the oxidized material, the second layer of the oxidized material, and the third layer of the oxidized material together may form an overall magnesium oxide (MgOₓ) tunnel barrier for the intermediate layer 150.

Although each of methods 800, 820, and 840 describes introducing a delay of time after deposition of a particular layer of an oxidizable material, in some embodiments, a delay of time may be introduced after deposition of each layer of an oxidizable material and before oxidation of each layer of the oxidizable material. For example, in each of methods 800, 820, and 840, a delay of time may be introduced after depositing a first layer of an oxidizable material but before oxidizing the deposited first layer of the oxidizable material, after depositing a second layer of an oxidizable material but before oxidizing the deposited second layer of the oxidizable material, and after depositing a third layer of an oxidizable material but before oxidizing the deposited third layer of the oxidizable material. Additionally, in each of methods 800, 820, and 840, more than three layers of an oxidizable material may be deposited and oxidized and/or less than three layers of an oxidizable material may be deposited and oxidized. In such cases, a delay of time may be introduced after deposition of a particular layer of an oxidizable material and before oxidation of the particular layer, or a delay of time may be introduced after deposition of each layer of an oxidizable material and before oxidation of each layer of the oxidizable material. In some cases, a delay of time may be introduced after deposition of a particular layer of an oxidizable material and before oxidation of the particular layer of the oxidizable material, for two or more particular layers in the intermediate layer 150.

While the steps of methods 500, 600, 700, 800, 820, and 840 have been depicted in a particular order, it is to be understood by those of ordinary skill in the art that such steps may be performed in any suitable order (e.g., in reverse order). Additionally, steps may be repeated, added, or omitted according to techniques known in the art. In some embodiments, such as the one shown in FIG. 1B, a second intermediate layer 150' may be formed above and in contact with free magnetic region 160. In such embodiments, a second fixed magnetic region 180 may then be formed above the second intermediate layer 150'. In some embodiments, an optional spacer region 170 may be formed above the second intermediate layer 150' to replace the second fixed region 180. In embodiments including a second intermediate layer 150', a second electrically conductive material 120 (e.g., an electrode, via, and/or conductor) may also be formed above spacer region 170, thereby providing electrical connectivity to magnetoresistive stack 100'.

Since suitable integrated circuit fabrication techniques (e.g., deposition, sputtering, evaporation, plating, etc.) that may be used to form the different regions are known to those of ordinary skill in the art, they are not described here in great detail. It should be noted that while not specifically described, various deposition processes (e.g., any physical vapor deposition (PVD) or chemical vapor deposition (CVD) process known in the art, such as sputtering, magneton sputtering, ion beam deposition, atomic layer deposition, evaporative techniques, etc.) may be used to form the various layers of the exemplary magnetoresistive stacks. Further, various lithographic processes, etching processes, or finishing steps common in the art (e.g., ion beam etching, chemical etching, chemical-physical planarization) may be performed after the formation of one or more layers of the exemplary magnetoresistive stacks.

In some embodiments, forming some of the regions may involve thin-film deposition processes, including, but not limited to, physical vapor deposition techniques such as ion beam sputtering and magnetron sputtering. Forming thin insulating layers may involve physical vapor deposition from an oxide target, such as by radio-frequency (RF) sputtering, or by deposition of a thin metallic film followed by an oxidation step, such as oxygen plasma oxidation, oxygen radical oxidation, or natural oxidation by exposure to a low-pressure oxygen environment. In some embodiments, formation of some or all of the regions of a magnetoresistive stack may also involve known processing steps such as, for example, selective deposition, photolithography processing, etching, etc., in accordance with any of the various conventional techniques known in the semiconductor industry.

In some embodiments, during deposition of the disclosed fixed and free regions, a magnetic field may be provided to set a preferred easy magnetization axis of the region (e.g., via induced anisotropy). Similarly, a strong magnetic field applied during the post-deposition high-temperature anneal step may be used to induce a preferred easy magnetization axis and a preferred pinning direction for any antiferromagnetically pinned materials. Additionally, deposition of fixed and free regions may occur in a variety of orders. For example, in some cases, a fixed or antiferromagnetic region may be formed before a free region in a bottom-pinned arrangement, and in other cases, the free region may be formed first on, e.g., a seeding layer, with the fixed region formed above the free region in a top-pinned arrangement.

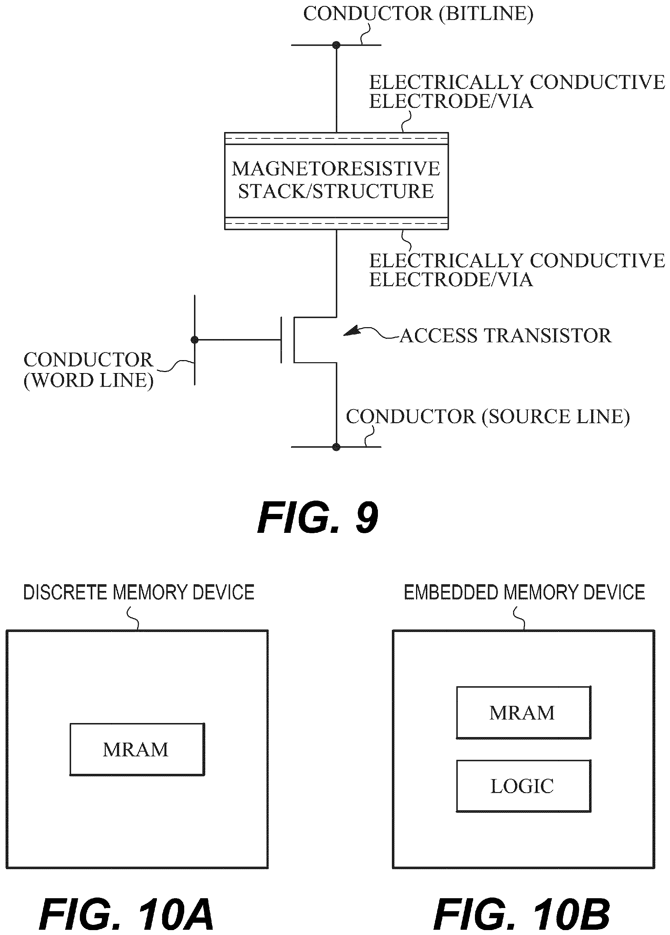

As alluded to above, the magnetoresistive devices of the present disclosure, including insertion layers 210 and/or interfacial layer 143 and/or intermediate layer 150 described herein, may be implemented in a sensor architecture or a memory architecture (among other architectures). For example, in a memory configuration, the magnetoresistive devices, including embodiment magnetoresistive stacks 100, 100' described herein, may be electrically connected to an access transistor and configured to couple or connect to various conductors, which may carry one or more control signals, as shown in FIG. 9. The magnetoresistive devices of the current disclosure may be used in any suitable application, including, e.g., in a memory configuration. In such instances, the magnetoresistive devices may be formed as an integrated circuit comprising a discrete memory device (e.g., as shown in FIG. 10A) or an embedded memory device having a logic therein (e.g., as shown in FIG. 10B), each including MRAM, which, in one embodiment is representative of one or more arrays of MRAM having a plurality of magnetoresistive stacks, according to certain aspects of certain embodiments disclosed herein.

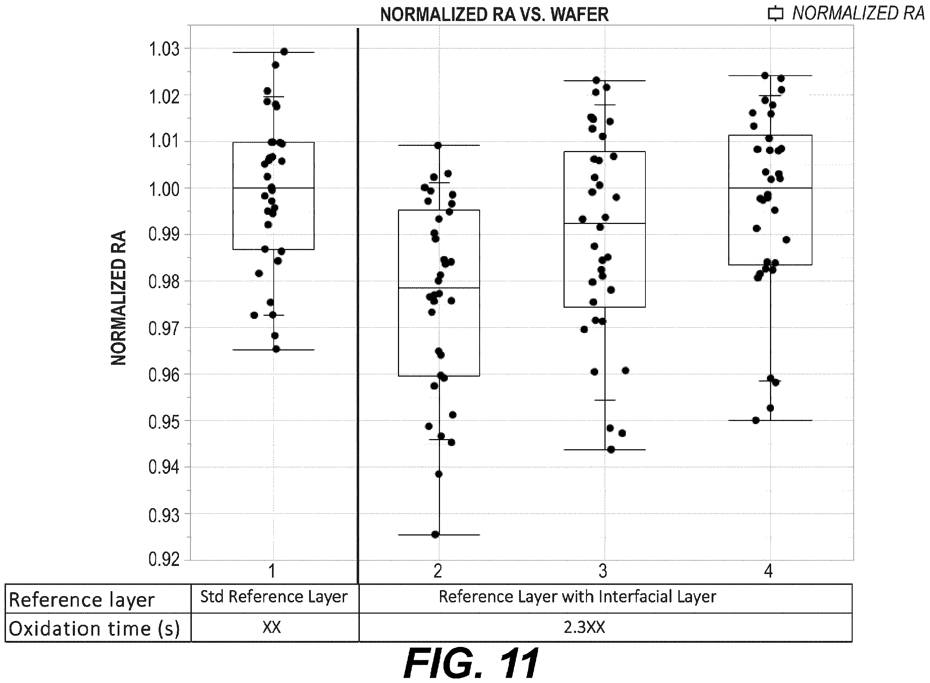

FIG. 11 is an exemplary quantile plot depicting normalized RA values for a plurality of wafers that have been tested with and without an interfacial layer 143 in accordance with one or more embodiments of the present disclosure. According to this example, the left quantile box represents RA values of a wafer tested without an interfacial layer 143 including cobalt (Co). The left quantile box illustrates various normalized RA values for an MTJ after a specified oxidation time "XX." The three quantile boxes to the right of the left quantile box each represent values of a wafer tested with an interfacial layer 143 including cobalt (Co), after a specified oxidation time "2.3XX" (e.g., oxidation time to oxidize one of the oxidizable material). As depicted, implementing an interfacial layer 143 including cobalt (Co) may be beneficial for lowering BER. For example, the median RA values of the right quantile boxes are generally equal to or less than the median RA values of the left quantile box while increasing oxidation time by a factor of 2.3.

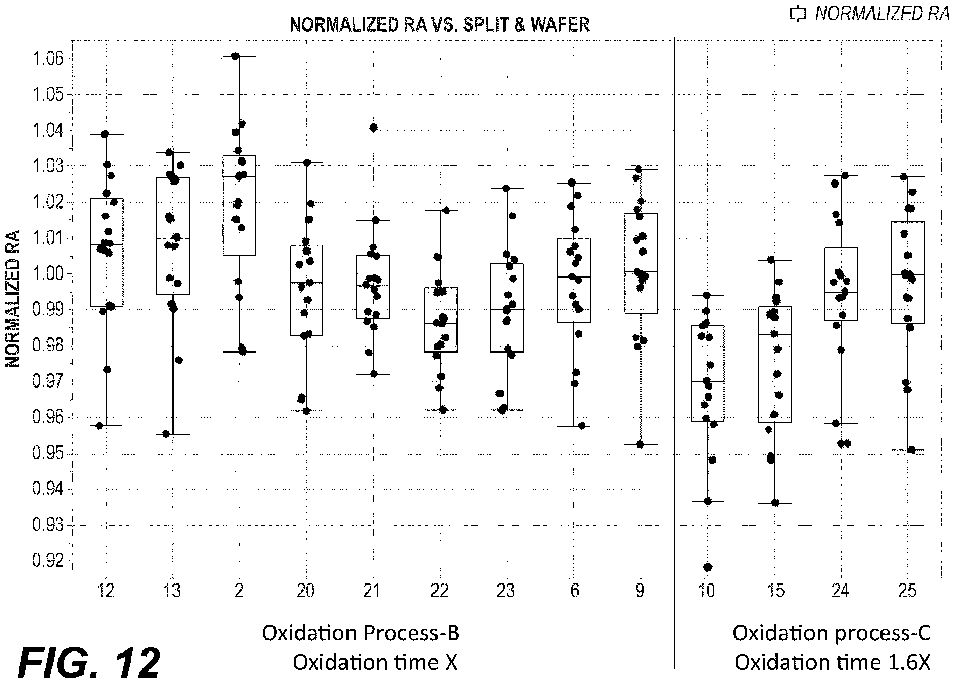

FIG. 12 is an exemplary quantile plot depicting normalized RA values for a plurality of wafers that have been tested with and without a delay of time step between a deposition and an oxidation process in accordance with one or more embodiments of the present disclosure. In this example, the left quantile boxes corresponding to "Oxidation Process-B" each represent RA values of a wafer tested without introducing a delay of time step between a deposition process and an oxidation process for the intermediate layer 150, as discussed in methods 800, 820, and 840. The right quantile boxes corresponding to "Oxidation Process-C" each represent RA values of a wafer tested with implementing a delay of time step between a deposition process and an oxidation process for the intermediate layer 150, as discussed in methods 800, 820, and 840 Each of the left quantile boxes illustrates various normalized RA values for an MTJ after a specified oxidation time "X." Each of the right quantile boxes illustrates various normalized RA values for an MTJ after a specified oxidation time "1.6X" (e.g., oxidation time to oxidize one of the oxidizable material with a delay of a certain amount of time, such as ranging from approximately 1 minute to approximately 30 minutes or from approximately 1 minute to approximately 25 minutes, as discussed previously). As depicted, implementing a delay of time step for fabrication of the intermediate layer 150 as discussed in methods 800, 820, and 840 may be beneficial for lowering bit error rate. For example, the median RA values of the right quantile boxes are generally equal to or less than the median RA values of the left quantile box while increasing oxidation time by a factor of 1.6.

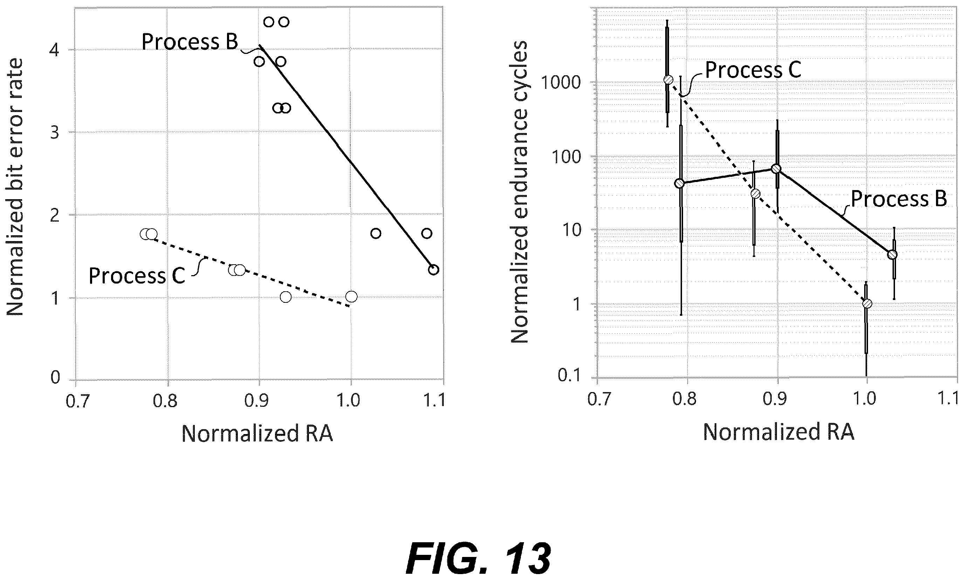

FIG. 13 depicts exemplary charts comparing a normalized BER and normalized endurance cycles against a normalized RA for two fabrication processes, according to one or more embodiments. In this example, "Process B" may refer to a fabrication process of a magnetoresistive stack that does not implement the delay of time steps between a deposition process and an oxidation process, while "Process C" may refer to a fabrication process of a magnetoresistive stack that does implement the delay of time steps between a deposition process and an oxidation process, as discussed in methods 800, 820, and 840. In the first chart on the left, process C obtains a lower normalized BER across all listed normalized RA values as compared to process B, with the greatest difference occurring for a normalized RA value of approximately 0.8.

In the chart on the right, process C obtains a higher normalized endurance cycle for normalized RA values between approximately 0.8 and approximately 0.9 as compared to process B, with the greatest difference occurring for a normalized RA value of approximately 0.8. Accordingly, an improvement in BER by implementing various aspects of the embodiments described herein may improve cycling endurance for a magnetoresistive device, especially at lower RA levels.

As described previously, the implementation of an interfacial layer 143 including cobalt (Co) and/or implementation of a delay of time step between a deposition process and an oxidation process for the intermediate layer 150, as discussed in methods 800, 820, and 840, may improve BER (e.g., raw BER at high time 0) for memory devices such as MRAM. An improvement in BER may decrease the need for reliance on ECC. An improvement or decrease in BER for a memory may be beneficial to overall circuit design and to cycling endurance.

In some aspects, the techniques described herein relate to a magnetoresistive stack, including: a fixed magnetic region, wherein the fixed magnetic region includes a reference layer; an interfacial layer disposed above the reference layer, the interfacial layer including cobalt (Co); an intermediate layer disposed above the interfacial layer; and a free magnetic region disposed above the intermediate layer.

In some aspects, the techniques described herein relate to a magnetoresistive stack, wherein the fixed magnetic region further includes: a first magnetic region; a coupling layer disposed on and in contact with the first magnetic region; a second magnetic region disposed on and in contact with the coupling layer; and a transition layer disposed above the second magnetic region.

In some aspects, the techniques described herein relate to a magnetoresistive stack, wherein the reference layer includes one or more elements with an electronegativity greater than the electronegativity of iron (Fe).

In some aspects, the techniques described herein relate to a magnetoresistive stack, wherein the interfacial layer has a thickness ranging from approximately 0.5 angstrom (Å) to approximately 5 Å.

In some aspects, the techniques described herein relate to a magnetoresistive stack, wherein the interfacial layer is disposed on and in contact with the reference layer, and wherein the intermediate layer is disposed on and in contact with the interfacial layer.

In some aspects, the techniques described herein relate to a magnetoresistive stack, wherein the intermediate layer includes a tunnel barrier, the tunnel barrier including magnesium oxide (MgOx).

In some aspects, the techniques described herein relate to a magnetoresistive stack, wherein the intermediate layer has a thickness ranging from approximately 8 Å to approximately 20 Å.

In some aspects, the techniques described herein relate to a magnetoresistive stack, wherein the interfacial layer consists of cobalt (Co).

In some aspects, the techniques described herein relate to a magnetoresistive stack, wherein the reference layer of the fixed magnetic region includes cobalt (Co), iron (Fe), and boron (B).

In some aspects, the techniques described herein relate to a method of manufacturing a magnetoresistive device, including: forming a first electrically conductive material above a substrate; forming a fixed magnetic region above the first electrically conductive material, the fixed magnetic region having a fixed magnetic state; forming an interfacial layer on or above the fixed magnetic region; forming an intermediate layer on or above the interfacial layer; and forming a free magnetic region above the intermediate layer, the free magnetic region having a first magnetic state and a second magnetic state, wherein forming the intermediate layer includes (a) depositing a layer of oxidizable material on or above the interfacial layer, and (b) oxidizing the deposited layer of oxidizable material to form a layer of oxidized material, wherein a delay of time is introduced after step (a) but before step (b).

In some aspects, the techniques described herein relate to a method, wherein the layer of oxidized material is a second oxidized layer in the intermediate layer, wherein forming the intermediate layer further includes: before step (a): depositing a first layer of oxidizable material on or above the interfacial layer; and oxidizing the deposited first layer of oxidizable material to form a first oxidized layer of oxidized material; and after step (b): depositing a third layer of oxidizable material on or above the second oxidized layer; and oxidizing the deposited third layer of oxidizable material to form a third oxidized layer of oxidized material.

In some aspects, the techniques described herein relate to a method, wherein the layer of oxidized material is a first oxidized layer in the intermediate layer, wherein forming the intermediate layer further includes: after step (b): depositing a second layer of oxidizable material on or above the first oxidized layer; oxidizing the deposited second layer of oxidizable material to form a second oxidized layer of oxidized material; depositing a third layer of oxidizable material on or above the second oxidized layer; and oxidizing the deposited third layer of oxidizable material to form a third oxidized layer of oxidized material.

In some aspects, the techniques described herein relate to a method, wherein the layer of oxidized material is a third oxidized layer in the intermediate layer, wherein forming the intermediate layer further includes: before step (a): depositing a first layer of oxidizable material on or above the interfacial layer; oxidizing the deposited first layer of oxidizable material to form a first oxidized layer of oxidized material; depositing a second layer of oxidizable material on or above the first oxidized layer; and oxidizing the deposited second layer of oxidizable material to form a second oxidized layer of oxidized material.

In some aspects, the techniques described herein relate to a method, wherein the fixed magnetic region includes: a first ferromagnetic region; a coupling layer disposed on and in contact with the first ferromagnetic region; a second ferromagnetic region disposed on and in contact with the coupling layer; a transition layer disposed above the second ferromagnetic region; and a reference layer disposed above the transition layer, wherein the interfacial layer is disposed on and in contact with the reference layer.

In some aspects, the techniques described herein relate to a method, wherein the intermediate layer includes a tunnel barrier, and wherein the oxidizable material includes magnesium (Mg).

In some aspects, the techniques described herein relate to a method, wherein the delay of time ranges from approximately 1 minute to approximately 25 minutes.

In some aspects, the techniques described herein relate to a method, wherein the interfacial layer includes cobalt (Co).

In some aspects, the techniques described herein relate to a method of manufacturing a magnetoresistive device, including: forming a first electrically conductive material above a substrate; forming a fixed magnetic region above the first electrically conductive material, the fixed magnetic region having a fixed magnetic state; forming an interfacial layer on or above the fixed magnetic region, the interfacial layer including cobalt (Co); forming an intermediate layer on or above the interfacial layer, the intermediate layer including a tunnel barrier; and forming a free magnetic region above the intermediate layer, the free magnetic region having a first magnetic state and a second magnetic state.

In some aspects, the techniques described herein relate to a method, wherein forming the intermediate layer includes (a) depositing a layer of oxidizable material on or above the interfacial layer, and (b) oxidizing the deposited layer of oxidizable material to form a layer of oxidized material, wherein a delay of time is introduced after step (a) but before step (b).

In some aspects, the techniques described herein relate to a method, wherein the layer of oxidized material is a second oxidized layer in the intermediate layer, wherein forming the intermediate layer further includes: before step (a): depositing a first layer of oxidizable material on or above the interfacial layer; and oxidizing the deposited first layer of oxidizable material to form a first oxidized layer of oxidized material; and after step (b): depositing a third layer of oxidizable material on or above the second oxidized layer; and oxidizing the deposited third layer of oxidizable material to form a third oxidized layer of oxidized material.

Other embodiments of the disclosure will be apparent to those skilled in the art from consideration of the specification and practice of the invention disclosed herein. It is intended that the specification and examples be considered as exemplary only, with a true scope and spirit of the invention being indicated by the following claims.

It follows a list with further embodiments of the invention:
Embodiment 1. A magnetoresistive stack, comprising:
   a fixed magnetic region, wherein the fixed magnetic region includes a reference layer;
   an interfacial layer disposed above the reference layer, the interfacial layer including cobalt (Co);
   an intermediate layer disposed above the interfacial layer; and
   a free magnetic region disposed above the intermediate layer.
Embodiment 2. The magnetoresistive stack with the features of embodiment 1, wherein the fixed magnetic region further includes:
   a first magnetic region;
   a coupling layer disposed on and in contact with the first magnetic region;
   a second magnetic region disposed on and in contact with the coupling layer; and
   a transition layer disposed above the second magnetic region.
Embodiment 3. The magnetoresistive stack with the features of embodiment 1, wherein the reference layer includes one or more elements with an electronegativity greater than the electronegativity of iron (Fe).
Embodiment 4. The magnetoresistive stack with the features of embodiment 1, wherein the interfacial layer has a thickness ranging from approximately 0.5 angstrom (Å) to approximately 5 Å.
Embodiment 5. The magnetoresistive stack with the features of embodiment 1, wherein the interfacial layer is disposed on and in contact with the reference layer, and wherein the intermediate layer is disposed on and in contact with the interfacial layer.
Embodiment 6. The magnetoresistive stack with the features of embodiment 1, wherein the intermediate layer includes a tunnel barrier, the tunnel barrier including magnesium oxide (MgOₓ).
Embodiment 7. The magnetoresistive stack with the features of embodiment 6, wherein the intermediate layer has a thickness ranging from approximately 8 Å to approximately 20 Å.
Embodiment 8. The magnetoresistive stack with the features of embodiment 1, wherein the interfacial layer consists of cobalt (Co).
Embodiment 9. The magnetoresistive stack with the features of embodiment 8, wherein the reference layer of the fixed magnetic region includes cobalt (Co), iron (Fe), and boron (B).
Embodiment 10. A method of manufacturing a magnetoresistive device, comprising:
   forming a first electrically conductive material above a substrate;
   forming a fixed magnetic region above the first electrically conductive material, the fixed magnetic region having a fixed magnetic state;
   forming an interfacial layer on or above the fixed magnetic region;
   forming an intermediate layer on or above the interfacial layer; and
   forming a free magnetic region above the intermediate layer, the free magnetic region having a first magnetic state and a second magnetic state,
   wherein forming the intermediate layer includes (a) depositing a layer of oxidizable material on or above the interfacial layer, and (b) oxidizing the deposited layer of oxidizable material to form a layer of oxidized material, wherein a delay of time is introduced after step (a) but before step (b).
Embodiment 11. The method with the features of embodiment 10, wherein the layer of oxidized material is a second oxidized layer in the intermediate layer, wherein forming the intermediate layer further comprises:
   before step (a):
      depositing a first layer of oxidizable material on or above the interfacial layer; and
      oxidizing the deposited first layer of oxidizable material to form a first oxidized layer of oxidized material; and
   after step (b):
      depositing a third layer of oxidizable material on or above the second oxidized layer; and
      oxidizing the deposited third layer of oxidizable material to form a third oxidized layer of oxidized material.
Embodiment 12. The method with the features of embodiment 10, wherein the layer of oxidized material is a first oxidized layer in the intermediate layer, wherein forming the intermediate layer further comprises:
   after step (b):
   depositing a second layer of oxidizable material on or above the first oxidized layer;
   oxidizing the deposited second layer of oxidizable material to form a second oxidized layer of oxidized material;
   depositing a third layer of oxidizable material on or above the second oxidized layer; and
   oxidizing the deposited third layer of oxidizable material to form a third oxidized layer of oxidized material.
Embodiment 13. The method with the features of embodiment 10, wherein the layer of oxidized material is a third oxidized layer in the intermediate layer, wherein forming the intermediate layer further comprises:
   before step (a):
   depositing a first layer of oxidizable material on or above the interfacial layer;
   oxidizing the deposited first layer of oxidizable material to form a first oxidized layer of oxidized material;
   depositing a second layer of oxidizable material on or above the first oxidized layer; and
   oxidizing the deposited second layer of oxidizable material to form a second oxidized layer of oxidized material.
Embodiment 14. The method with the features of embodiment 10, wherein the fixed magnetic region comprises:
   a first ferromagnetic region;
   a coupling layer disposed on and in contact with the first ferromagnetic region;
   a second ferromagnetic region disposed on and in contact with the coupling layer;
   a transition layer disposed above the second ferromagnetic region; and
   a reference layer disposed above the transition layer,
   wherein the interfacial layer is disposed on and in contact with the reference layer.
Embodiment 15. The method with the features of embodiment 10, wherein the intermediate layer includes a tunnel barrier, and wherein the oxidizable material includes magnesium (Mg).
Embodiment 16. The method with the features of embodiment 10, wherein the delay of time ranges from approximately 1 minute to approximately 25 minutes.
Embodiment 17. The method with the features of embodiment 10, wherein the interfacial layer includes cobalt (Co).
Embodiment 18. A method of manufacturing a magnetoresistive device, comprising:
   forming a first electrically conductive material above a substrate;
   forming a fixed magnetic region above the first electrically conductive material, the fixed magnetic region having a fixed magnetic state;
   forming an interfacial layer on or above the fixed magnetic region, the interfacial layer including cobalt (Co);
   forming an intermediate layer on or above the interfacial layer, the intermediate layer including a tunnel barrier; and
   forming a free magnetic region above the intermediate layer, the free magnetic region having a first magnetic state and a second magnetic state.
Embodiment 19. The method with the features of embodiment 18, wherein forming the intermediate layer includes (a) depositing a layer of oxidizable material on or above the interfacial layer, and (b) oxidizing the deposited layer of oxidizable material to form a layer of oxidized material, wherein a delay of time is introduced after step (a) but before step (b).
Embodiment 20. The method with the features of embodiment 19, wherein the layer of oxidized material is a second oxidized layer in the intermediate layer, wherein forming the intermediate layer further comprises:
   before step (a):
      depositing a first layer of oxidizable material on or above the interfacial layer; and
      oxidizing the deposited first layer of oxidizable material to form a first oxidized layer of oxidized material; and
   after step (b):
      depositing a third layer of oxidizable material on or above the second oxidized layer; and
      oxidizing the deposited third layer of oxidizable material to form a third oxidized layer of oxidized material.

## Claims

1. A magnetoresistive stack, comprising:
a fixed magnetic region, wherein the fixed magnetic region includes a reference layer;
an interfacial layer disposed above the reference layer, the interfacial layer including cobalt (Co);
an intermediate layer disposed above the interfacial layer; and
a free magnetic region disposed above the intermediate layer.

2. The magnetoresistive stack of claim 1, wherein the fixed magnetic region further includes:
a first magnetic region;
a coupling layer disposed on and in contact with the first magnetic region;
a second magnetic region disposed on and in contact with the coupling layer; and
a transition layer disposed above the second magnetic region.

3. The magnetoresistive stack of claim 1, wherein the reference layer includes one or more elements with an electronegativity greater than the electronegativity of iron (Fe).

4. The magnetoresistive stack of claim 1, wherein the interfacial layer has a thickness ranging from approximately 0.5 angstrom (Å) to approximately 5 Å.

5. The magnetoresistive stack of claim 1, wherein the interfacial layer is disposed on and in contact with the reference layer, and wherein the intermediate layer is disposed on and in contact with the interfacial layer.

6. The magnetoresistive stack of claim 1, wherein the intermediate layer includes a tunnel barrier, the tunnel barrier including magnesium oxide (MgOₓ); in particular wherein the intermediate layer has a thickness ranging from approximately 8 Å to approximately 20 Å.

7. The magnetoresistive stack of claim 1, wherein the interfacial layer consists of cobalt (Co); in particular wherein the reference layer of the fixed magnetic region includes cobalt (Co), iron (Fe), and boron (B).

8. A method of manufacturing a magnetoresistive device, comprising:
forming a first electrically conductive material above a substrate;
forming a fixed magnetic region above the first electrically conductive material, the fixed magnetic region having a fixed magnetic state;
forming an interfacial layer on or above the fixed magnetic region;
forming an intermediate layer on or above the interfacial layer; and
forming a free magnetic region above the intermediate layer, the free magnetic region having a first magnetic state and a second magnetic state,
wherein forming the intermediate layer includes (a) depositing a layer of oxidizable material on or above the interfacial layer, and (b) oxidizing the deposited layer of oxidizable material to form a layer of oxidized material, wherein a delay of time is introduced after step (a) but before step (b).

9. The method of claim 8, wherein the layer of oxidized material is a second oxidized layer in the intermediate layer, wherein forming the intermediate layer further comprises:
before step (a):
depositing a first layer of oxidizable material on or above the interfacial layer; and
oxidizing the deposited first layer of oxidizable material to form a first oxidized layer of oxidized material; and
after step (b):
depositing a third layer of oxidizable material on or above the second oxidized layer; and
oxidizing the deposited third layer of oxidizable material to form a third oxidized layer of oxidized material; and/or
wherein the layer of oxidized material is a first oxidized layer in the intermediate layer, wherein forming the intermediate layer further comprises:
after step (b):
depositing a second layer of oxidizable material on or above the first oxidized layer;
oxidizing the deposited second layer of oxidizable material to form a second oxidized layer of oxidized material;
depositing a third layer of oxidizable material on or above the second oxidized layer; and
oxidizing the deposited third layer of oxidizable material to form a third oxidized layer of oxidized material; and/or
wherein the layer of oxidized material is a third oxidized layer in the intermediate layer, wherein forming the intermediate layer further comprises:
before step (a):
depositing a first layer of oxidizable material on or above the interfacial layer;
oxidizing the deposited first layer of oxidizable material to form a first oxidized layer of oxidized material;
depositing a second layer of oxidizable material on or above the first oxidized layer; and
oxidizing the deposited second layer of oxidizable material to form a second oxidized layer of oxidized material.

10. The method of claim 8, wherein the fixed magnetic region comprises:
a first ferromagnetic region;
a coupling layer disposed on and in contact with the first ferromagnetic region;
a second ferromagnetic region disposed on and in contact with the coupling layer;
a transition layer disposed above the second ferromagnetic region; and
a reference layer disposed above the transition layer,
wherein the interfacial layer is disposed on and in contact with the reference layer.

11. The method of claim 8, wherein the intermediate layer includes a tunnel barrier, and wherein the oxidizable material includes magnesium (Mg).

12. The method of claim 8, wherein the delay of time ranges from approximately 1 minute to approximately 25 minutes.

13. The method of claim 8, wherein the interfacial layer includes cobalt (Co).

14. A method of manufacturing a magnetoresistive device, comprising:
forming a first electrically conductive material above a substrate;
forming a fixed magnetic region above the first electrically conductive material, the fixed magnetic region having a fixed magnetic state;
forming an interfacial layer on or above the fixed magnetic region, the interfacial layer including cobalt (Co);
forming an intermediate layer on or above the interfacial layer, the intermediate layer including a tunnel barrier; and
forming a free magnetic region above the intermediate layer, the free magnetic region having a first magnetic state and a second magnetic state.

15. The method of claim 14, wherein forming the intermediate layer includes (a) depositing a layer of oxidizable material on or above the interfacial layer, and (b) oxidizing the deposited layer of oxidizable material to form a layer of oxidized material, wherein a delay of time is introduced after step (a) but before step (b); in particular
wherein the layer of oxidized material is a second oxidized layer in the intermediate layer, wherein forming the intermediate layer further comprises:
before step (a):
depositing a first layer of oxidizable material on or above the interfacial layer; and
oxidizing the deposited first layer of oxidizable material to form a first oxidized layer of oxidized material; and
after step (b):
depositing a third layer of oxidizable material on or above the second oxidized layer; and
oxidizing the deposited third layer of oxidizable material to form a third oxidized layer of oxidized material.
